# EUROPEAN PATENT SPECIFICATION

(11) **EP 0 209 749 B1**
(45) Date of publication and mention of the grant of the patent: **29.12.1993**
(21) Application number: 86108653.6
(22) Date of filing: 25.06.1986
(51) Int. Cl.: G11C 8/00, G11C 7/00

(54) **Memory system and interface therein**
Speichersystem und Schnittstelle darin
Système de mémoire et interface y comprise

(30) Priority: 25.06.1985 JP 138304/85; 25.06.1985 JP 138305/85; 15.07.1985 JP 156707/85; 18.07.1985 JP 158592/85; 28.08.1985 JP 187420/85
(43) Date of publication of application: 28.01.1987
(73) Proprietor: Ascii Corporation, Minato-ku Tokyo (JP)
(72) Inventor: Ishii, Takatoshi, Oome-shi Tokyo (JP)
(74) Representative: Eitle, Werner, Dipl.-Ing.

(56) References cited:
- EP-A- 0 121 453
- DE-A- 3 313 441
- US-A- 3 681 763
- US-A- 3 943 487
- US-A- 4 092 728

## Description

### BACKGROUND OF THE INVENTION

### 1. Field of the Invention

The present invention relates to a memory system.

### 2. Description of the Prior Art

Recently, a video memory has been remarkably increased in capacity as the resolving power of a screen has been enhanced and also as the number of colors to be displayed has been increased.

By the way, in general, when the capacity of the video memory is expanded, there arises a problem that the time required to process data to be displayed is extended in proportion to the capacity increased. To solve this problem, conventionally a display data processor has been improved so as to speed up the time to process the display data. However, there is a limit in the memory access speed.

In other words, when a display memory is of a word-structure, the time for accessing each pixel will be unfavorably delayed. Also, when the display memory has a side-by-side-pixel structure, there arises another problem that bit locations must be processed within a word resulting in the delayed access.

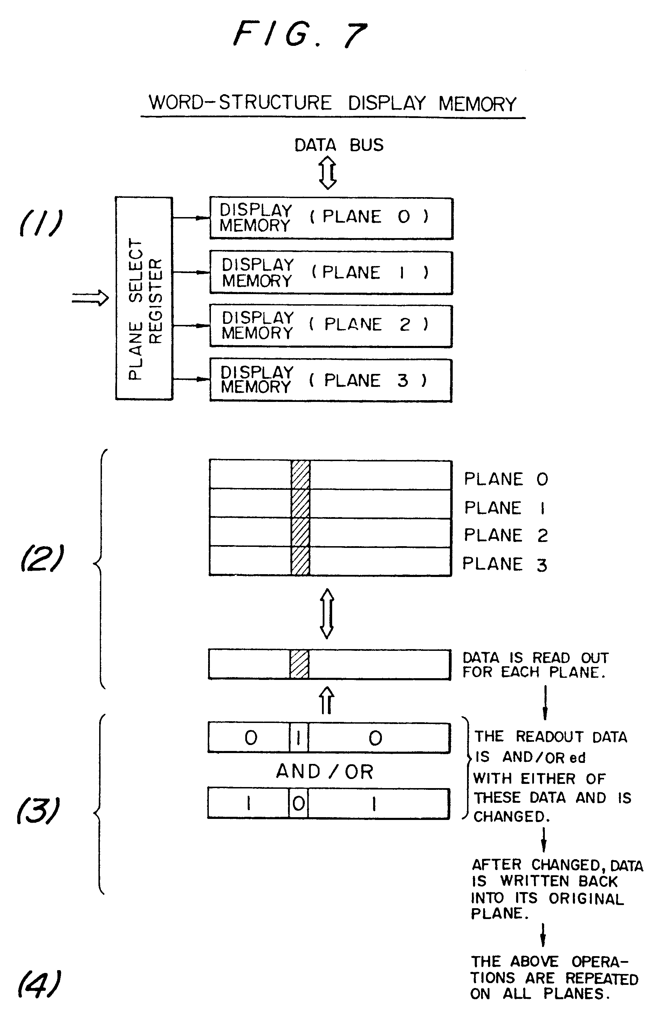

In particular, in the display memory having the word structure, there is a problem which will be described below. In connection with this, we refer to Fig. 7 which is an explanatory view of a display memory having a word structure.

When character information is to be written into the display memory having the word structure, it can be expected that the value of a plane select register is set according to a color code and, as data, a font pattern is written, (see Fig. 7 (1)). In this case, the character information can be written at a very high speed.

However, if a background color is not "0", then the information or data must be written into respective planes separately. Therefore, the greater the number of planes to write is, the slower the writing speed is, (that is, the writing operation requires time which is proportional to the number of the planes).

Also, when only 1 dot of a display screen is to be written, further longer time is necessary for processing it. This is because, after data is read out from each of the planes (Fig. 7 (2)), only one or more bit locations to be altered are written back to "1" or "0" (Fig. 7 (3)), which operation must be performed repetitively for all of the planes (Fig. 7 (3)).

In general, when display data is written, most of images/pixels are formed by combining dot-by-dot writing operations and thus the writing operations thereof requires a very long time for processing.

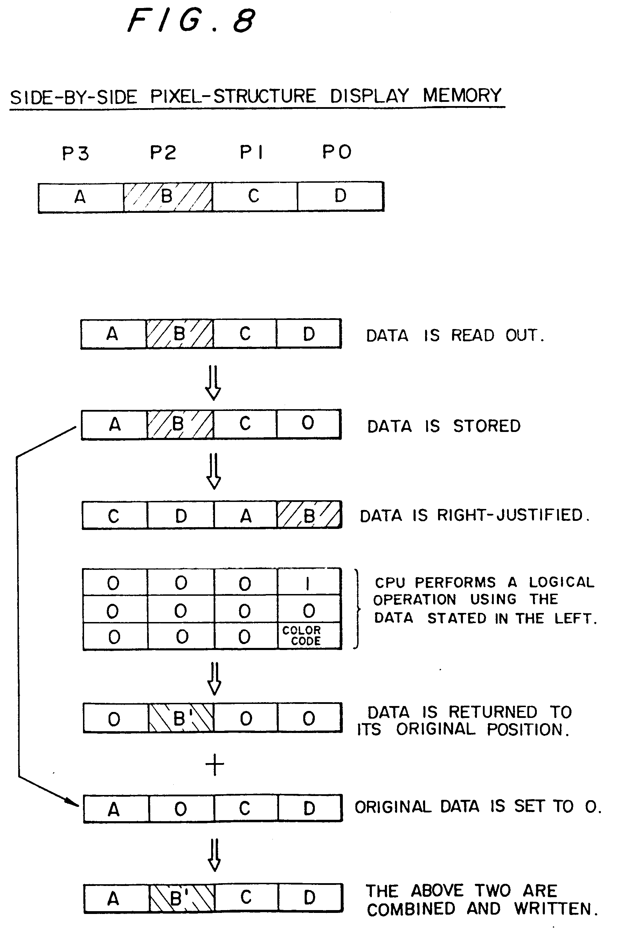

On the other hand, in case of the display memory having the side-by-side-pixel structure, there exists another problem as follows. In connection with this, we refer to Fig. 8 which illustrates an explanatory view of a display memory incorporating a side-by-side-pixel structure.

When writing display information into the display memory, a font pattern must be extended to a display color and a background color before it is written, which makes the time for writing longer. Also, when a pixel length is long, the number of pixels which can be written at a time is reduced so that it takes further longer time to write the display information.

In the side-by-side-pixel structure, it is easier to perform a dot-by-dot writing operation than in the above-mentioned word structure, but bit locations within a word vary according to pixel positions. For this reason, in order to update a pixel, a CPU or a video data processor must read out a word in which the pixel exists, then shift the pixel to a position of the bit 0 and then process it, wherever the pixel to be updated is located, next return the pixel to its prior-to-shift location, and write it back after adjacent data is added thereto.

Thus, the display memory having the word structure and the display memory with the side-by-side-pixel structure have their own problems, respectively, and memory access provides a considerable limit to the enhancement of performance in the image processings.

Also, in the image processings, when its boundary is detected or painted (that is, an area within the boundary is painted with a predetermined color paint), it is necessary to detect a color code which is written in an image memory.

In this case, data is read out from the above-mentioned image memory, a color code for each pixel is extracted from the data, and the extracted color code is compared with a desired color code in pixels.

Whichever the image memory employs the word structure or the pixel structure, in order to compare the color codes, it is necessary to extract a color code for each desired pixel. This means that it takes long time to compare and detect the above-mentioned color codes. This problem remains unsolved in the prior art.

Further, the conventional memory unit is only capable of storing a given piece of information and simply reading and writing the information, that is, it has only a single function. Thanks to the progress of a semiconductor technology, however, there is now a possibility of further functions in addition to the single function to read and write being realized.

The conventional memory unit having such single function shows a tendency to become less estimated at an increasing tempo. This is a problem in that it decreases reasonable profits.

The conventional memory unit has also been increased gradually in capacity, and, following this, there is a tendency that its additional circuits may be expanded.

On the other hand, in the field of an image device, the memory unit can be used in two ways, that is, it can be used as an image memory or as a program memory. The image memory has its own access method, while the program memory has its own access method. These two access methods are different from each other.

Therefore, in a data processing system to store large files of image data, there must be equipped an image memory of a large capacity and a program memory of a large capacity, and at the same time the peripheral circuits of such memories must be large-sized accordingly, so that the whole system, disadvantageously, must be of a large-size.

An orthogonal memory system having a 2-dimensional array of memory devices, and interfaces enabling access in either dimension is shown in US-A-3681763, but only complete words can be accessed, and thus processing of bit locations within a word still requires a shift operation.

### SUMMARY OF THE INVENTION

The present invention aims at reducing the disadvantages found in the above-mentioned conventional memory units.

According to the invention, there is provided a memory system to read or write data through data lines, said memory system comprising;
a memory array including a plurality of memory interfaces and a plurality of memories arranged one-dimensionally in a word direction via said memory interfaces, each of said memory interfaces comprising word-direction data buffers serving as a word-direction input/output interface, bit direction data buffers serving as a bit direction input/output interface and also adapted to operate independent of said word-direction data buffer; and data buffer select means for selecting either of said two data buffers; characterised by direction control means for controlling the direction of each of said two data buffers in accordance with a reading or writing operation on the memory contents of said memory system;
and wherein said memory array is split in the word direction into individually addressable pixels, each pixel comprising a plurality of bits, corresponding bits of a plurality of pixels being connected together at the side of said word direction data buffer away from the memory, and being connected to corresponding least significant bits of an input/output data bus, each of the bits of said plurality of pixels are connected to individual bits of said input/output data bus via the bit-direction data buffer, such that any single pixel can be accessed using the least significant bits of said data bus, or multiple pixels can be accessed simultaneously depending on the data buffer select means.

For a better understanding of the invention, embodiments will be described by way of example with reference to the following drawings.

### BRIEF DESCRIPTION OF THE DRAWINGS

Fig. 1 is a block diagram of a memory system;
Fig. 1A is a block diagram of a modification of the system shown in Fig. 1;
Fig. 2 is a circuit diagram to show concretely the main portions of the system in Fig. 1;
Fig. 3 is an explanatory view of preferred features of the invention;
Fig. 4 is a block diagram of further preferred features of the invention;
Fig. 5 is a view of a still further embodiment of a memory system, showing a memory array thereof;
Fig. 6 is an explanatory view of a yet another memory system;
Fig. 7 is an explanatory view of a display memory having a word structure;
Fig. 8 is an explanatory view of a display memory having a side-by-side pixel structure;
Fig. 9 is a circuit diagram of a modification of the embodiment shown in Fig. 3;
Fig. 10 is a block diagram of a modification of the embodiment shown in Fig. 9;
Fig. 11 is a circuit diagram of a modification of the memory system shown in Fig. 2A;
Fig. 12 is an explanatory view to illustrate an operation to compare color codes in the embodiment shown in Fig. 10;
Fig. 13 is an explanatory view to illustrate an operation to detect the existence of color codes in the embodiment shown in Fig. 10;
Fig. 14 is a block diagram showing an overall view of the memory system;
Fig. 15 is a circuit diagram to show concretely the embodiment shown in Fig. 14;
Fig. 16 is a circuit diagram to show an example of a timing control circuit shown in Fig. 14;
Fig. 17 is a time chart to show a program memory access in the circuit of Fig. 15;
Fig. 18 is a time chart to show a VRAM access in the circuit of Fig. 15;
Fig. 19 is a time chart to show a memory command cycle in the circuit of Fig. 15; and,
Fig. 20 is a block diagram of a modification of the embodiment shown in Fig. 15.

### DETAILED DESCRIPTION OF PREFERRED EMBODIMENTS OF THE INVENTION

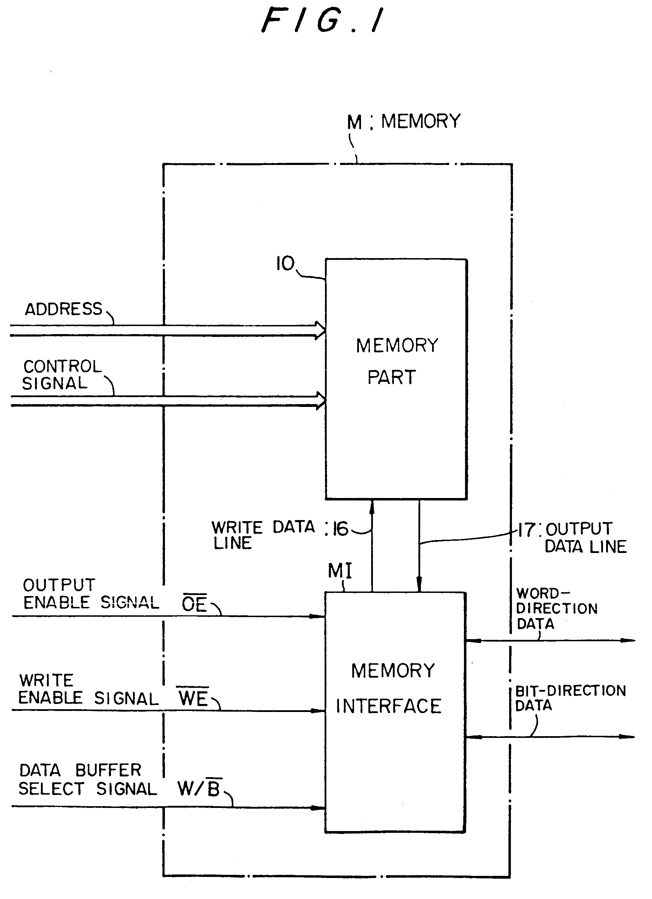

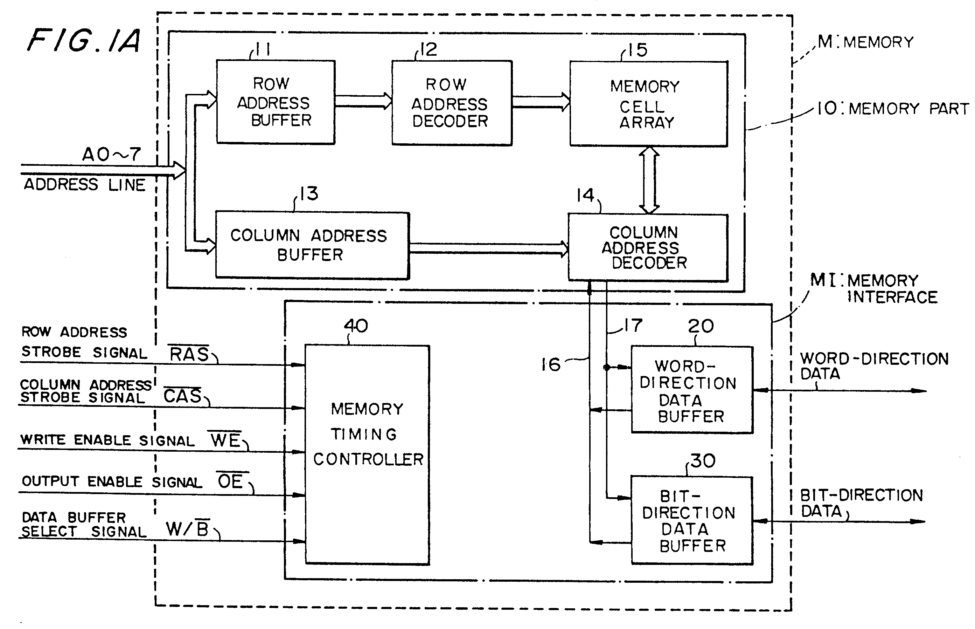

Referring first to Fig. 1, there is shown a block diagram of an embodiment of a memory system.

Memory M comprises a memory part 10 and a memory interface MI which serves as an interface for Memory Part 10. Memory Part 10 comprises a row address buffer 11, a row address decoder 12, a column address buffer 13, and a column address decoder 14, as shown in Fig. 1A.

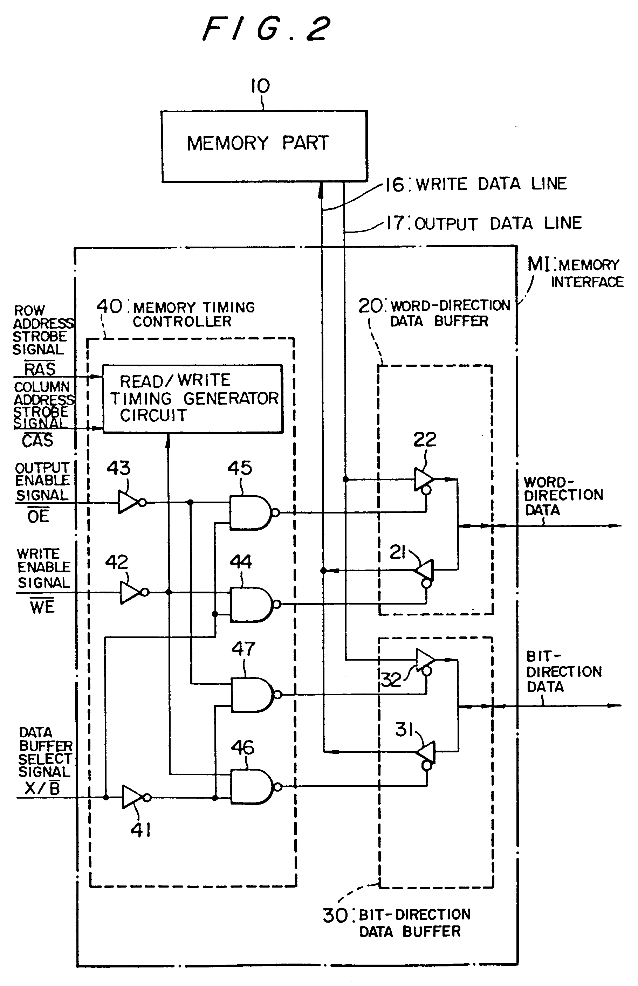

In Fig. 2, there is illustrated a circuit diagram which shows concretely Memory Interface MI employed in the above-mentioned memory system.

Memory Interface MI includes a word-direction data buffer 20, a bit-direction data buffer 30, and a memory timing controller 40.

Word-direction Data Buffer 20 includes a buffer in its output direction and a buffer 22 in its output direction. Also, Bit-direction Data Buffer 30 includes a buffer 31 in its input direction and a buffer 32 in its output direction.

Memory Timing Controller 40 includes three inverters 41, 42, 43, and four NAND circuits 44, 45, 46, 47.

Next, we will describe the operation of the above-mentioned memory system.

Generally, in an image memory, data is accessed in two directions: that is, one of them is a word direction in which access is performed based on processings in units of words observable from a CPU or a display controller; and, the other is a bit direction in which access is carried out based on processings in units of pixels.

Now, when Memory Part 10 is to be accessed in the word direction, "1" is given to Memory Timing Controller 40 as a data buffer select signal. This prepares a condition to open NAND Gates 44, 45. In this case, in order to write a given piece of data into Memory Part 10, "0" is given as a write enable signal and "1" is given as an output enable signal.

Then, a signal "0", which has passed through Inverter 42 and NAND Circuit 44, turns on Buffer 21 and thus the word-direction data goes to Memory Part 10 via Buffer 21 and a write data line 16. In this instance, since the output of Inverter 43 goes to a "0" and the output of NAND Circuit 45 goes to a "1", Buffer 22 is turned off, thereby preventing the data in an output data line 17 from going out of Memory M.

In the above case, in order to read out the given data from Memory Part 10, "0" is given as an output enable signal and "1" is given as a write enable signal. As a result of this, a signal, which has passed through Inverter 43 and NAND Circuit 45, turns on Buffer 22 and thus the data specified by the then address is output from Memory Part 10 externally of Memory M through Output Data Line 17 and Buffer 22.

Also, when Memory Part 10 is to be accessed in the bit direction, "0" is applied as the data buffer select signal to Memory Timing Controller 40, thereby preparing a condition to open NAND Gates 46, 47. In this case, in order to write a given piece of data into Memory Part 10, a "0" is applied as the write enable signal and a "1" is applied as the output enable signal.

Consequently, a signal, which has passed through Inverter 42 and NAND Circuit 46, turns on Buffer 31, with the result that the bit-direction data starts for Memory Part 10 through Buffer and Write Data Line 16. In this case, the output of Inverter 43 goes to a "0" and the output of NAND Gate 47 goes to a "1", thereby turning off Buffer 32, with the result that the data in Output Data Line 17 is kept from going out externally of Memory M.

In the above case, in order to read out the given data from Memory Part 10, a "0" is applied as the output enable signal and a "1" is given as the write enable signal. In consequence, a signal, which has passed through Inverter 43 and NAND Gate 47, turns on Buffer 32, so that the data specified by the then address is output from Memory Part 10 externally of Memory M via Output Data Line 17 and Buffer 32.

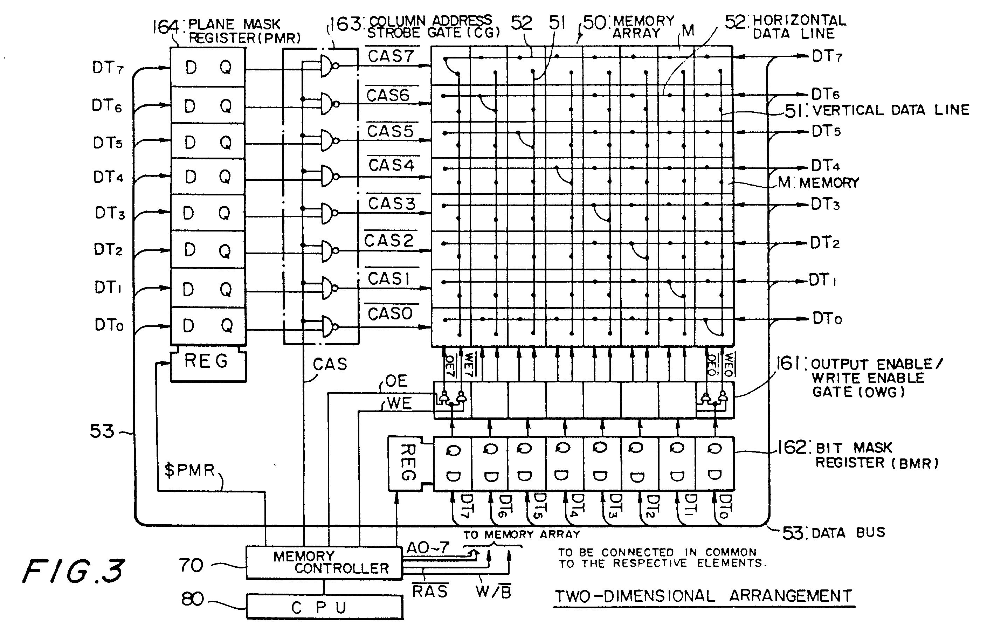

Referring now to Fig. 3, there is shown an explanatory view of another embodiment of the invention.

In Fig. 3, Memory Array 50 can be obtained by two-dimensionally arranging a plurality of Memories M shown in Fig. 1. Specifically, in Memory Array 50, a number of Memories M are combined in a horizontal direction to structure a word, while a number of Memories M are combined in a vertical direction to structure a pixel (display 1 dot).

Also, the word-direction data terminals of Memories M arranged in the same word direction are connected to one another and the connection points thereof are then connected to vertical data lines 51 respectively, while the pixel-direction data terminals of Memories M arranged in the same pixel direction are connected to one another and the connection points thereof are then connected to horizontal data lines 52, respectively.

Further, the above-mentioned data lines 51, 52 are connected to one another. In this case, the same bits in Data Lines 51, 52 are connected with one another. As a result of this, Data Lines 51 and 52 can provide the same data bus, namely, Data Bus 53, respectively. The reason why Data Bus 53 can be provided in common in this manner is that the above-mentioned vertical and horizontal data lines 51 and 52 are never used at the same time.

Then, in a plurality of Memories M arranged in the same vertical direction, the write enable signal terminals of such memories M are connected with one another and the points of connection thereof are then connected with the write enable signal terminals of an output enable/write enable gate 161. Also, in a plurality of Memories M arranged in the same vertical direction, the output enable signal terminals of such memories M are connected with one another and the connection points thereof are then connected with the output enable signal terminals of Output Enable/Write Enable Gate 161.

On the other hand, in a plurality of Memories M arranged in the same horizontal direction, the column address strobe terminals of such memories M are connected with one another and the connecting points thereof are then connected with the corresponding connection terminals of a column address strobe gate 163.

Now, outputs A 0 ∼ 7, low address strobe signal and data buffer select signal from a memory controller ( or, a video processor) 70 are supplied in common to all of Memories M in Memory Array 50.

Plane Mask Register 164 is adapted to hold mask information for each of planes in Memory Array 50 in accordance with instructions from CPU 80 or Memory Controller 70. The outputs of Plane Mask Register 164 are supplied to Column Address Strobe Gate 163, where they are ANDed with a column address strobe signal to provide column address strobe signals for the respective planes in Memory Arrary 50.

Bit Mask Register 162 is adapted to hold mask information for each of pixels in Memory Array 50 in accordance with instructions from CPU 80 or Memory Controller 70. The outputs of Bit Mask Register 162 are supplied to Output Enable/Write

Enable Gate 161, where they are ANDed with an output enable signal and a write enable signal separately to provide output enable signals and write enable signals for the respective pixels in Memory Array 50.

Next, we will describe the operation of the above-mentioned embodiment.

At first, a case where CPU 80 performs a word-direction access will be explained.

In this case, the word-direction access can be selected by setting the data buffer select signal to "1". Mask data is set according to a color to be written into Plane Mask Register 164/a plane to be used, Bit Mask Register 162 is all set to "1s", and the memory write is then executed. After then, the outputs A 0 ∼ 7, low address strobe signal, column address strobe signal and write enable signal are output from Memory Controller 70 at predetermined timings.

In a case where CPU 80 runs a write operation, in parallel with the operation of Memory Controller 70, write data is output from CPU 80 and is written in the word direction/horizontal direction (X direction) via Data Line 51 and Data Bus 53. In this case, the same write data is written into each of the authorized planes. That is, in order to perform the word-direction write operation, at least one of the bits of Plane Mask Register 164 may be set to "1", or two or more bits thereof may be set to "1s" at the same time. As a result of this, the same write data is simultaneously written into the bits that are set to "1s". Prior to the above writing, if arbitrary data is set in Bit Mask Register 162, then the writing can be performed only into the arbitray bit(s) or arbitrary portion(s) of the word.

When a word-direction readout is executed, if one of the bits of Plane Mask Register 164 is set to a "1", then the word-direction read data corresponding to the bit that is set to a "1" can be obtained in Data Bus 53.

Next, we will describe a case where CPU 80 performs a bit-direction (pixel-direction) access.

First, the bit-direction access is selected by setting the data buffer select signal to a "0". Then, Plane Mask Register 164 is all set to "1s", and one of bits of Bit Mask Register 162 is set, whereby either a read operation or a write operation can be executed through Data Line 52 and Data Bus 53. In this case, the values of A 0 ∼ 7 are determined correspondingly to a word address in which a pixel to be accessed exists, and the values of Bit Mask Register 162 are determined correspondingly to the bit position within the word.

Pixel data, whatever pixel length it may have, can be accessed at a right-justified bit position in the data bus. That is, in Fig. 8, the pixel data can be accessed at a position illustrated by " to be (right-) justified to the position of Bit 0". Therefore, the processings by CPU 80 can be performed by a very simple operation.

In the above-mentioned embodiment, a plurality of planes can be word-accessed simultaneously for a time equal to a word access time in a conventional memory system of a word structure, and at the same time the pixel access can be performed at a higher speed than a pixel access time in a conventional memory system of a pixel structure.

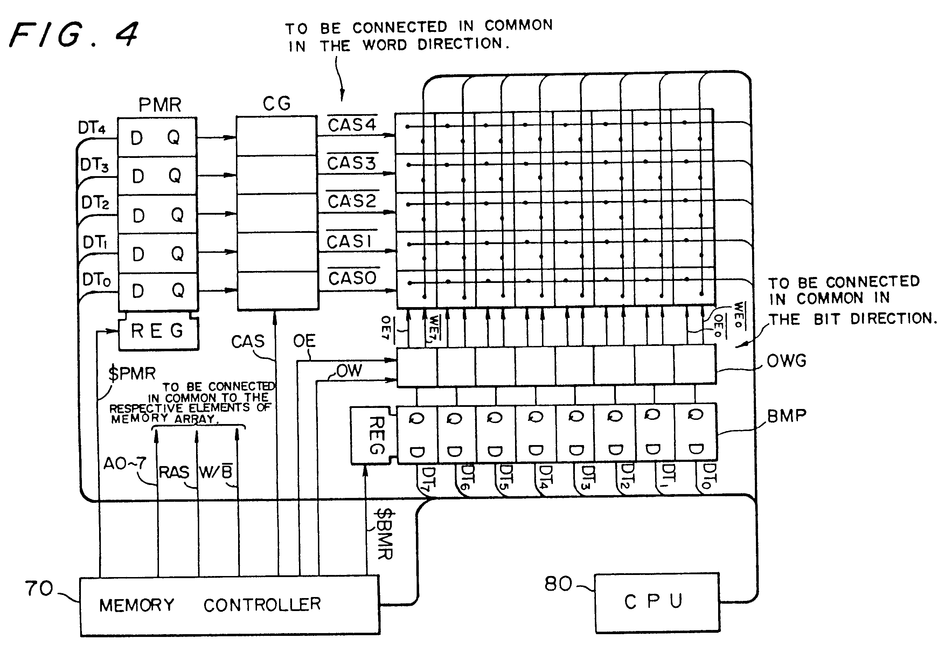

Referring now to Fig. 4, there is shown a block diagram of another embodiment of the invention.

In this embodiment, the number of bits in the word-direction is greater than that of bits in the bit direction. Specifically, there are 8 bits in the word direction, while there are 5 bits in the bit direction.

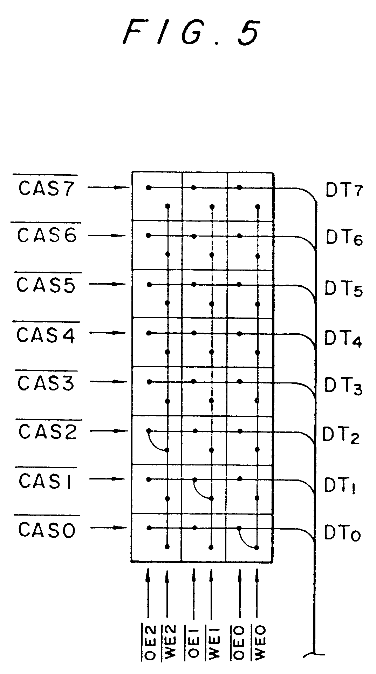

Referring now to Fig. 5, there is shown a further illustration of a memory array.

In this figure , the number of bits in the word direction is smaller than that of bits in the bit direction. Specifically, this embodiment has 3 bits in the word direction and 8 bits in the bit direction.

Also, Bit Mask Register 162 and Plane Mask Register 164 are logically identical with each other, and they are called differently as they are applied to different uses. That is, Bit Mask Register 162 and Plane Mask Register 164 can be replaced by each other by changing their names and uses with each other.

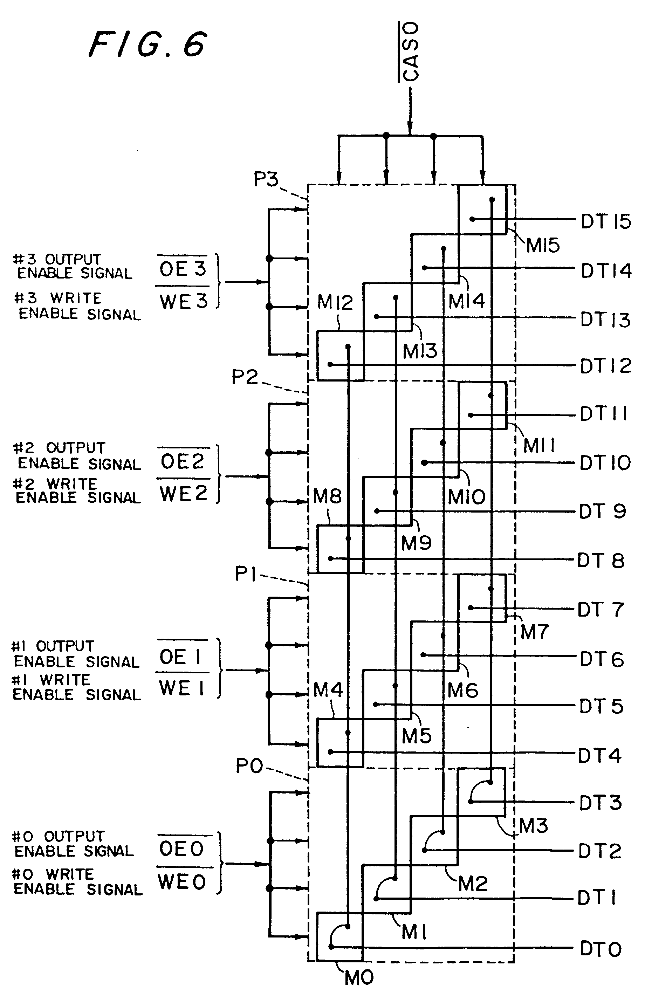

Referring now to Fig. 6, there is shown a still further memory system.

In this figure , there are arranged 16 Memories M one-dimensionally in the word direction, these 16 Memories M are divided into four pixels, and, among the corresponding bits in the respective pixels, the memories M are connected to one another. Also, the pixel access is to be executed in units of pixels.

In other words, 16 Memories M 0 ∼ M 15 are arranged in the word direction and these memories M 0 ∼ M 15 are connected with Data Lines DT 0 ∼ DT 15, respectively. Also, 16 Memories M 0 ∼ M 15 are divided into four pixels P 0, P 1, P 2, P3, that is, Memories 0 ∼ M 3 are included in Pixel P 0, Memories M 4 ∼ M 7 are included in Pixel P 1, Memories M 8 ∼ M 11 are included in Pixel P 2, and Memories M 12 ∼ M 15 are included in Pixel P 3.

And, Memory M 0 in Pixel P 0, Memory M 4 in Pixel P 1, Memory M 8 in Pixel P 2 and Memory M 12 in Pixel P 3 are connected to one another. Also, Memory M 1, in Pixel P 0, Memory M 5 in Pixel P 1, Memory M 9 in Pixel P 2, and Memory M 13 in Pixel P 3 are connected to one another. Such connection is to be repeated in the other memories M in a similar manner among the corresponding bits in the respective pixels.

Next, the operation of the above-mentioned system will be described below.

For the word access, a structure consisting of 1 plane of 16 bits is employed and thus the 16 bits can be read and written simultaneously, while for the pixel access the read/write operation can be performed only for the pixel that is specified among Pixels P 0 ∼ P 3. In this case, the write data (read data) must be always transmitted only by means of Data Lines DT 0 ∼ DT 3.

For example, when only Pixel P 2 is written (read), only the #2 write enable signal (the #2 read enable signal) is supplied and only Pixel P 2 is accessed. And, when writing the data, the write data is transmitted via Data Lines DT 0 ∼ DT 3, while, when reading out the data, the read data is transmitted through Data Lines DT 0 ∼ DT 3. Therefore, when writing or reading out the data, there is eliminated the need to shift the data as shown in Fig. 8. As a result of this, the time required to process the data can be reduced.

In Fig. 6, although it also seems that Memories M are arranged two-dimensionally, this is because Memories M are respectively shifted right and left in order to illustrate clearly the operations of the respective pixels. Also, in the system in Fig. 6, the number of Memories M arranged in the word direction may be other than 16, and the memories M arranged in the word direction may be divided into other number of pixels than 4.

Further, as Memory Part 10, other memories such as an SRAM and the like than a DRAM may be used.

According to the above-mentioned system both the word access and pixel access are possible and, in either case, the processings can be performed at a high speed.

Referring now to Fig. 1A, there is shown a block diagram to illustrate a modified version of the system shown in Fig. 1.

Memory M includes a memory part 10 and a memory interface MI. Memory Part 10 comprises a row address buffer 11 for holding a row address out of address information, a row address decoder 12 for decoding the row address, a column address buffer 13 for holding a column address out of the address information, a column address decoder 14 for decoding the column address, and a memory cell array 15 for storing a given piece of data. Memory Interface MI comprises a word-direction data buffer 20, a bit-direction data buffer 30, and a memory timing controller 40.

Word-direction-Data Buffer 20 serves as the word-direction input/output interface of Memory Cell Array 15, while Bit-direction Data Buffer 30 serves as the bit-direction input/output interface of Memory Cell Array 15. Also, Word-direction Data Buffer 20 and Bit-direction Data Buffer 30 are adapted to operate independent of each other.

Memory Timing Controller 40 receives a row address strobe signal for giving a timing to take in the row address, a column address strobe signal for giving a timing to take in the column address, a write enable signal for giving a timing to writing into Memory Cell Array 15, an output enable signal for giving a timing for reading data written into Memory Cell Array 15, and a data buffer select signal, and outputs a given control signal.

The above-mentioned data buffer select signal is used to select either Word-direction Data Buffer 20 or Bit-direction Data Buffer 30.

For example, 16 bits of address information are divided into a row address and a column address, which addresses are then transmitted alternately by means of address lines A 0 ∼ 7. The low address, after held in Row Address Buffer 11, is decoded by Decoder 17, while the column address is decoded by Column Address Decoder 14 after it is held in Column Address Buffer 13. The above-mentioned two addresses are supplied to Memory Cell Array 15, and, for the memory cells that correspond to the addresses, a writing or reading operation is carried out.

Referring again to Fig. 3, there is provided only one plane mask register 164 and thus one and the same plane mask register is used to write and read the data. However, a plane mask register for data writing and a plane mask register for data reading may also be provided separately. In such separate provision, immediately after a plane is read, data can be written into another plane. Therefore, with such structure, data processings can be performed quickly when a plane to read is different from a plane to write.

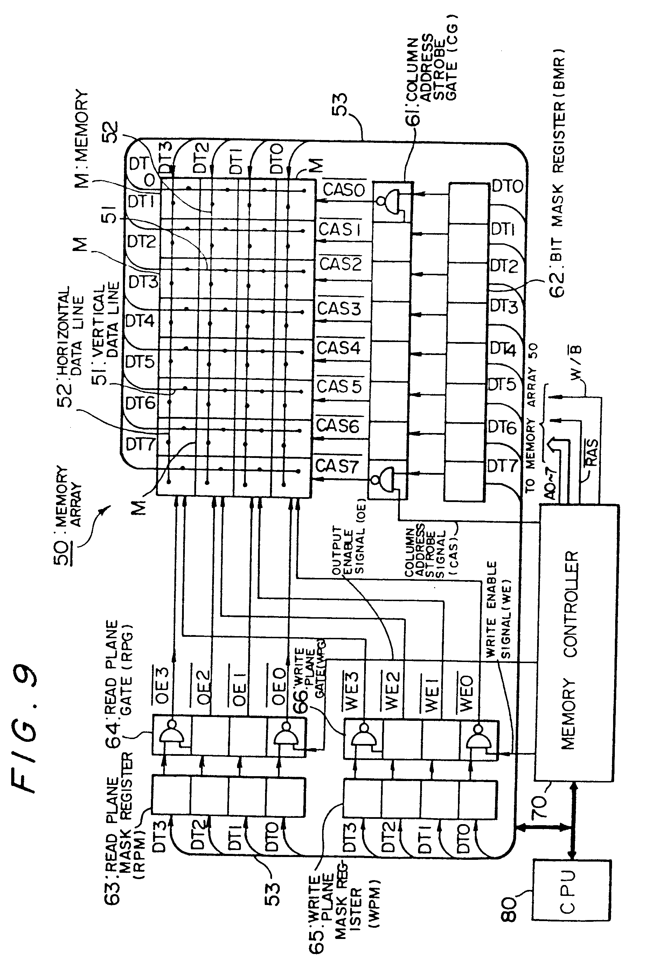

Referring now to Fig. 9, there is shown a block diagram of a modified version of the embodiment shown in Fig. 3.

In Fig. 9, Memory Arrary 50 is composed of a plurality of Memories M which are arranged two-dimensionally. In Memory Array 50, Memories M are combined horizontally to structure a word, while Memories M are combined vertically to structure 1 pixel (display 1 dot).

The word-direction data terminals of Memories M arranged in the same word direciton are connected to one another and the connection points thereof are then connected to data lines which extend in the vertical direction. Also, the pixel-direction data terminals of Memories M arranged in the same pixel direction are connected to one another and the connection points thereof are then connected to horizontal data lines 52, respectively.

Further, the above-mentioned data lines 51, 52 are connected to one another. In this case, the corresponding bits of Data Lines 51, 52 are connected to one another, which enables Data Lines 51 and 52 to provide the same data bus 53. The reason why Data Bus 53 can be provided in common by the vertical data lines 51 and horizontal data lines 52 is that the vertical and horizontal data lines 51 and 52 are not used at the same time. The above-mentioned explanation is the same as in the embodiment of Fig. 3.

Also in Fig. 9, in relation to predetermined Memories M existing in the word direction within Memory Array 50, there are provided a read plane mask register 63 and a read plane gate 64 as word-direction read inhibit mask means to inhibit and mask reading operations.

Among a plurality of Memories M arranged in the same horizontal direction, the output enable signal terminals of the respecitve memories M are connected to one another, and the connection points thereof are then connected the output terminals of Read Plane Gate 64, respectively.

Further in Fig. 9, in relation to predetermined Memories M existing in the word direction within Memory Array 50, there are provided a write plane mask register 65 and a write plane gate 66 as word-direction write inhibit mask means to inhibit and mask writing operations.

Among a plurality of Memories M arranged in the same horizontal direction, the write enable signal terminals of the respective memories M are connected to one another and the connection points thereof are then connected to the output terminals of Write Plane Gate 66, respectively.

Moreover, in Fig. 9, there are provided a column address strobe gate 61 and a bit mask register 62, as bit-direction inhibit mask means to inhibit and mask reading or writing operations, in relation to predetermined Memories M existing in the bit direction within Memory Array 50.

And, among a plurality of Memories M arranged in the same vertical direction, the column address strobe terminals of the respective memories M are connected to one another, and the connecting points thereof are then connected to the corresponding connection terminals of Column Address Strobe Gate 66.

In relation to predetermined Memories M present in the bit direction within Memory Array 50, there are provided a column address strobe gate 61 and a bit mask register 62, as bit-direction inhibit mask means to inhibit and mask reading or writing operations.

Among a plurality of Memories M arranged in the same vertical direction, the column address strobe terminals of the respective memories M are connected to one another, and the connection points thereof are then connected to the corresponding connection terminals of Column Address Strobe Gate 61.

The outputs A 0 ∼ 7, row address strobe signal, and data buffer select signal from Memory Controller (or, Viedo Processor) 70 are supplied in common to all of Memories M in Memory Array 50.

Read Plane Mask Register 63 and Write Plane Mask Register 65 are respectively adapted to hold mask information for the respective planes in Memory Array, according to instructions from CPU 80 or Memory Controller 70.

Bit Mask Register 62 is adapted to hold mask information for the respective pixels in Memory Array 50, in accordance with instructions from CPU 80 or Memory Controller 70. The outputs of Bit Mask Register 62 are supplied to Output Enable/Write Enable Gate 61, where they are ANDed with the column address strobe signals from Memory Controller 70 to provide column address strobe signals for the respective pixels in Memory Arrary 50.

Next, we will describe the operation of the embodiment shown in Fig. 9.

At first, a case where CPU 80 performs a word-direction access will be explained.

In this case, by setting the data buffer select signal to a "1", the word-direction access is selected. Mask data is set in Write Plane Mask Register 65 according to colors to be written/planes to be used, thereby setting Bit Mask Register 62 all to "1s". After then, if a memory access is executed, then the outputs A 0 ∼ 7, row address strobe signal, column address strobe signal, write enable signal and output enable signal are output from Memory Controller 70 at given timings, respectively.

When CPU 80 runs the writing operation, concurruntly with the operation of Memory Controller 70, the write data is output from CPU 80 and is written in the word direction/horizontal direction via Data Bus 53 and Data Line 51. In this case, the same write data is written into the respective authorized planes. In other words, when the word-direction writing is performed, at least one bit of Write Plane Mask Register 65 may be set to a "1", or two or more bits thereof may be set to "1s" simultaneously. As a result of this, the same write data is written into the bit or bits set to "1s", concurrently.

If arbitrary data is set in Bit Mask Register 62 prior to the above-mentioned writing, then the writing can be performed only in an arbitrary bit of the word or in an arbitrary portion thereof.

When the word-direction readout is performed, if one bit of Read Plane Mask Register 63 is set to a "1", then the word-direction read data that corresponds to the bit set to a "1" can be obtained in Data Bus 53 through Data Line 51.

The above-mentioned description about the operation of the embodiment shown in Fig. 9 is basically similar to that of the embodiment in Fig. 3.

However, the embodiment of Fig. 9 is different from that of Fig. 3 in that Plane Mask Register 65 for data writing and Plane Mask Register 63 for data reading are provided individually. Therefore, in the embodiment of Fig. 9, immediately after a plane is read out, data can be written into another plane. As a result of, in a case where a plane to read and a plane to write are different from each other, processings can be done quickly.

Next, we will describe a case where CPU 80 runs the bit-direction (pixel-direction) access. This description is also similar to that of Fig. 3 in principle.

First, the bit-direction access is selected by setting the data buffer select signal to a "0". Then, Read Plane Mask Register 63 and Write Plane Mask Register 65 are all set to "1s", one bit of Bit Mask Register 62 is set, and a read or write operation is carried out via Data Line 52 and Data Bus 53. In this case, correspondingly to a word address in which a pixel to be accessed is present, the values of A 0 ∼ 7 are determined, and, correspondingly to the bit position within the word, the value of Bit Mask Register 62 is determined.

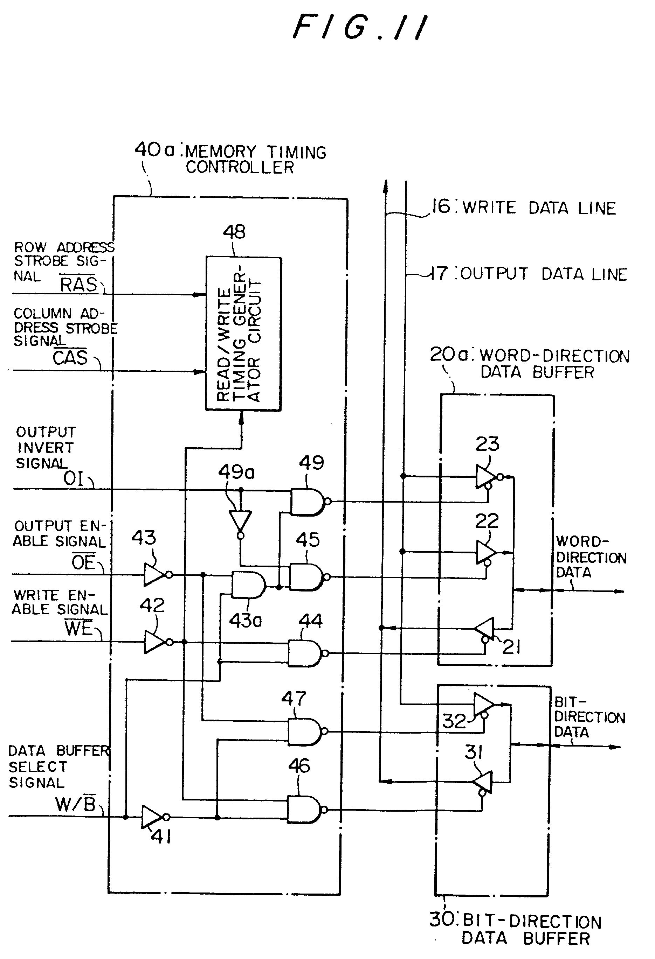

Referring now to Fig. 11, there is shown a circuit diagram of a modification of the embodiment shown in Fig. 2.

The embodiment of Fig. 11 is different from the embodiment of Fig. 2 in that AND Circuit 43a, NAND Circuit 49, Inverter 49a and Buffer 23 are newly provided.

Next, we will describe the operation of the embodiment shown in Fig. 11. This operation is basically similar to that of the system of Fig. 2.

In the embodiment in Fig. 11, however, in order to reverse and output the data stored in Memory Cell Array 15, the output enable signal may be set to a "0" and at the same time an output reverse signal may be set to a "1". As a result of this, the data is output externally of Memory M via Buffer 23 instead of Buffer 22 in Word-direction Data Buffer 20a, so that the output data is output after it is reversed.

However, the above-mentioned output reverse signal is effective only when the data buffer select signal is a "1", because it can be output only for the word-direction data.

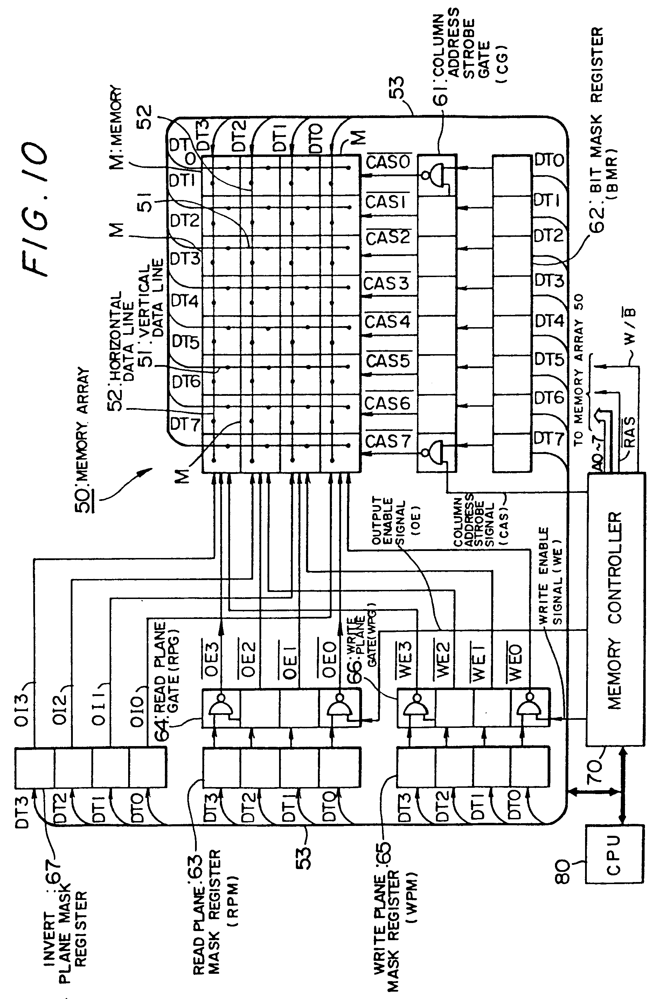

Now, Fig. 10 illustrates a block diagram of a modified version of the embodiment shown in Fig. 9.

The embodiment in Fig. 10 differs from the embodiment in Fig. 9 in that Invert Plane Mask Register 67 is newly provided.

Invert Plane Mask Register 67 is used to instruct the reverse of an output signal in a given plane within Memory Array 50. Also, in this embodiment, among a plurality of Memories M arranged in the same horizontal direction, the output reverse signal terminals of the respective memories M are connected to one another, and the connecting points thereof are then connected to the output terminals of Invert Plane Mask Register 67.

Also, Invert Plane Mask Register 67 is adapted to hold reverse instruction information for a given screen within Memory Array 50 in accordance with an instruction from CPU 80 or Memory Controller 70.

Next, we will describe a case where color codes are compared.

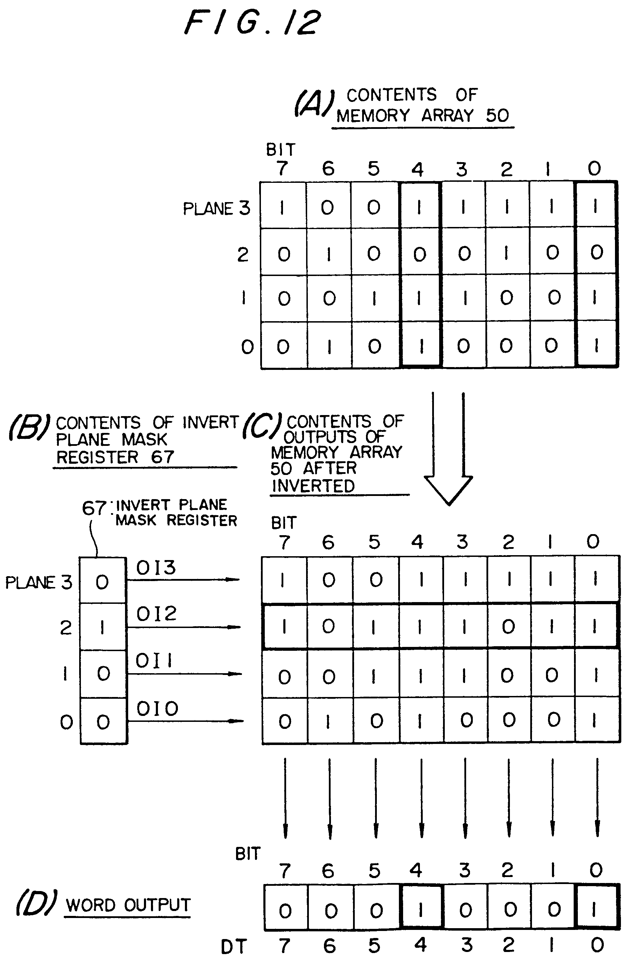

First, it is assumed that a portion of the contents of Memory Array 50 is in a state as shown in Fig. 12(A). In this state, a given color code, for example, "1 0 1 1" is to be detected. This code, "1 0 1 1", is shown by a heavy line in Fig. 12(A). That is, in Fig. 12(A), the signal "1 0 1 1" exists in Bit 4 and Bit 0, respectively.

In this case, the complement(a signal obtained when a color code signal is inverted) of the above-mentioned color code signal is "0 1 0 0", and this is set in Invert Plane Mask Register 67. A state set in this manner is shown in Fig. 12(B). That is, all bits that correspond to planes 3, 1, 0 are set to "0s", and only the bit that corresponds to Plane 2 is set to a "1". And, only the signal of Plane 2 set to a "1" is reversed or inverted before it is output.

In other words, the output invert signal of Memory M corresponding to the plane that is set to a "1" goes to a "1". On the other hand, the output enable signal is a "0" and the "0" inverted to a "1" by means of Inverter 43, while the data buffer select signal is a "1", with the result that AND Circuit 43a outputs a "1". And, due to the "1" of the above-mentioned output invert signal, NAND Circuit 49a outputa a "0". Thus, Data Buffer 23 inverts its output signal.

The contents of the outputs in the respective planes in Memory Array 50 after inverted in the above-mentioned case are shown in Fgi. 12(C). In Fig. 12(C), a signal which is invertedly output is shown by a heavy line.

In this state, the outputs of Memory Array 50 are wired ANDed on Vertical Data Line 51, with the result that an 8-bit signal shown in Fig. 12(D) is obtained. This result appears on Data Bus 53 as a word output.

Therefore, in a given bit, if there is present at least one "0" in the outputs corresponding to the respective planes, then the output corresponding to the given bit goes to a "0", while,in a given bit, if the outputs corresponding to the respective planes are all in "1s", then the output corresponding to the given bit goes to a "1". Therefore, only when the pixel-direction color codes are matched, the word output(s) corresponding the bit(s) matched will go to a "1" or "1s".

And, since the above-mentioned output inversion and wired AND operations are executed in the read cycle of Memories M, the color codes can be detected at a high speed.

Next, we will describe an operation to detect the existence of the color codes.

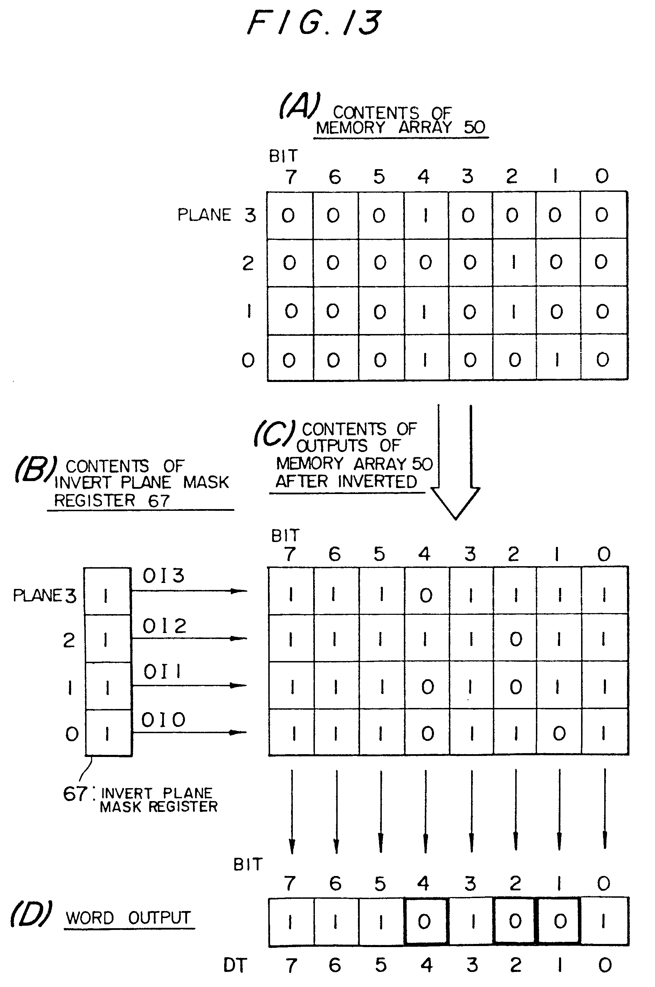

At first, a portion of the contents of Memory Array 50 is assumed to be in a state as shown in Fig. 13(A). In this state, the existence of any of the color codes is detected.

In Fig. 13(A), the color codes are present in Bit 4, Bit 2, and Bit 1, respectively. In this case, Invert Plane Mask Register 67 is set such that the outputs of all of the planes are inverted. That is, "1 1 1 1" is set in Invert Plane Mask Register 67. A state set in this manner is shown in Fig. 13(B).

In Fig. 13(C), there are shown the contents of the outputs for the respective planes in Memory array 50 after inverted in the above-mentioned case.

In this state, the outputs of Memory Array 50 are wired ANDed on Vertical Data Line 51, with the result that a signal of 8 bits shown in Fig. 13(D) can be obtained. This result will appear on Data Bus 53 as a word output.

Accordingly, in a given bit, if there is at least one "0" in the outputs corresponding to the respective planes, the output corresponding to the given bit, then, goes to a "0", while, in a given bit, if the outputs corresponding to the respective planes are all in "1s", then the output corresponding to the given bit will go to a "1". As a result of this, if any of the color codes are present, then the word output corresponding to the bit in which the color codes are present will go to a "0". In the above-mentioned case, however, it is assumed that, even if a code "0 0 0 0" is present, no color code exists.

And, since the above-mentioned output inversion and wired AND operations are executed in the read cycle of Memories M, it is possible to detect the existence of the color codes at a high speed.

Although, in the above-mentioned embodiment, four planes are employed, the number of the planes employed may be another if it is two or more. Also, 1 word may be composed of any number of bits. In Memory Array 50, the number of bits in the word direction may be greater or smaller than that of the bit-direction bits.

According to the above-mentioned embodiment of the invention, it is possible to reduce the time required to compare given color codes among color codes stored in an image memory, and at the same time to reduce the time required to detect the existence of any color codes.

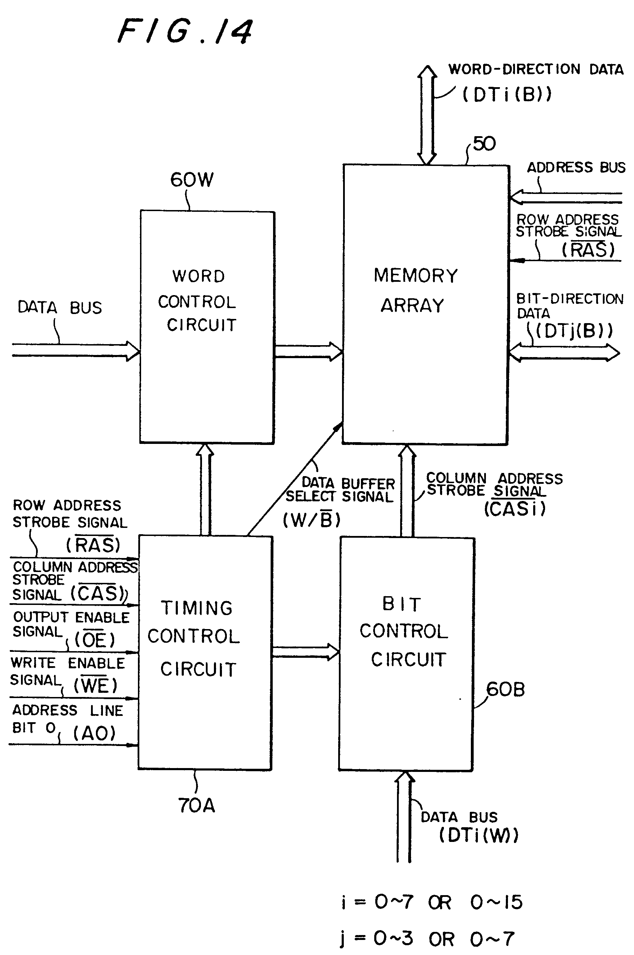

Referring now to Fig. 14, there is shown a block diagram to illustrate the outlines of another embodiment of the invention.

In this figure, the embodiment comprises a memory array 50, a word control circuit 60W, a bit control circuit 60B, and a timing control circuit 70A to control the timings of the above-mentioned respective circuits.

Word Control Circuit 60W is a circuit to control a word-direction or plane-direction control line in Memory Array 50, in which there are present a number of circuits corresponding to the number i (e.g., i= 0 ∼ 7) of bits forming a word.

Bit Control Circuit 60B is a circuit to control a bit-direction or pixel-direction control line, in which there are present a number of circuits corresponding the number j (e.g., j = 0 ∼ 3) of bits forming a pixel.

A data bus going to Word Control Circuit 60W and a data line going to Bit Control Circuit 60B are in common with each other in any data bus, and an address line is supplied to the whole memory array 50.

Memory Array 50 is composed of a plurality of memories, each of which is used as a VRAM(Video RAM) or a program memory.

Timing Control Circuit 70A receives a row address strobe signal, a column address strobe signal, an output enable signal, a write enable signal, and an address line bit 0(A 0) signal, and also outputs various control signals.

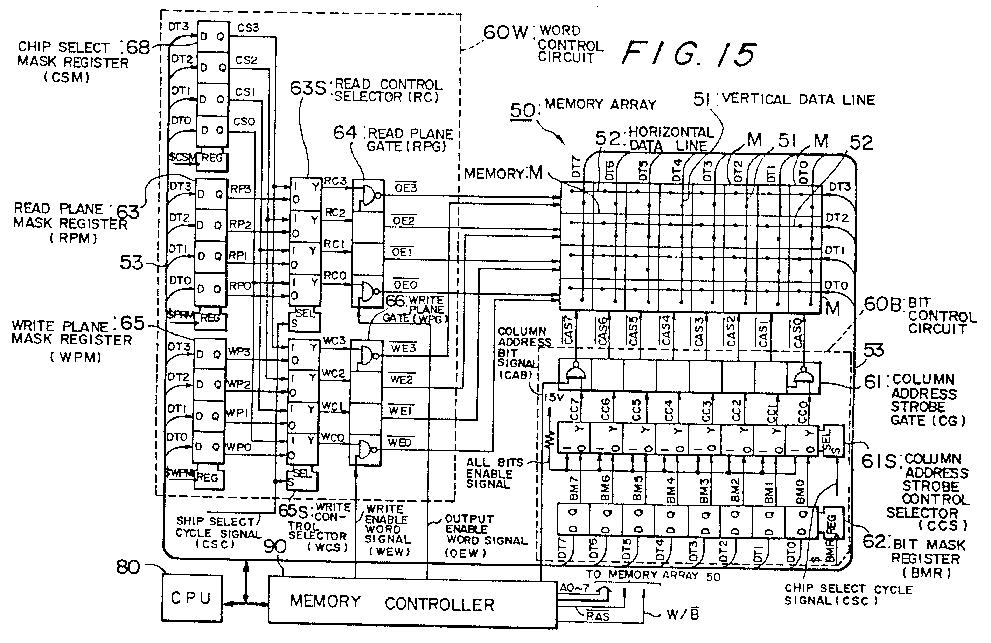

In Fig. 15, there is shown a block diagram to illustrate the whole of the embodiment shown in Fig. 14 as well as to illustrate a modified version of the embodiment shown in Fig. 10.

The embodiment of Fig.15 differs from that of Fig.10 in that a column address strobe control selector (CCS) 61S, a read control selector (RC) 63S and a write control selector (WCS) 65S are newly provided, and also that a chip select mask register (CSM) 68 is provided in place of Invert Plane Mask Register 67.

Next, we will describe the inner parts of Word Control Circuit 60W.

In Word Control Circuit 60W, there is provided Chip Select Mask Register 68 which serves to hold the information to select chips in Memory Array 50.

With respect to given Memories M existing in the word direction within Memory Array 50, as word-direction read inhibit mask means to inhibit and mask their reading operations, there are provided a read plane mask register 63, Read Control Selector 63S, and a read plane gate 64.

Read Control Selector 63S is a selector to select chip select information and read plane mask information in accordance with a chip select cycle signal.

Among a plurality of Memories M arranged in the same horizontal direction, the output terminals of Read Plane Gate 64 are interconnected with the output enable signal terminals of the respective memories M.

Also, within Word Control Circuit 60W, as word-direction write inhibit mask means to inhibit and mask the writing operations of given Memories M existing in the word-direction in Memory Array 50, there are provided a write plane mask register 65, Write Control Selector 65S, and a write plane gate 66.

Write Control Selector 65S is a selector to select the chip select information and write plane mask information in accordance with a chip select cycle signal.

Also, among a plurality of Memories M arranged in the same horizontal direction, the write enable signal terminals of the respective memories M are connected with one another, and the connection points thereof are then connected with the output terminals of Write Plane Gate 66.

Next, the internal parts of Bit Control Circuit 60B will be discussed.

In Bit Control Circuit 60B, with respect to given memories M present in the bit direction within the above-mentioned memory array, as bit-direction inhibit mask means to inhibit and mask the read or write operations thereof, there are provided a column address strobe gate 61, Column Address Strobe Control Selector 61S, and a bit mask register 62.

Column Address Strobe Control Selector 61S is a selector to select column address strobe controlling signals (all-enable signals and bit mask information) in accordance with respective memory cycles.

Among a plurality of Memories M arranged in the same vertical direction, the column address strobe terminals of the respective memories M are connected with one another and the connecting points thereof are then connected with the corresponding connection terminals of Column Address Strobe Gate 61.

Memory Controller 90 (or, video processor) includes therein Timing Controller 70, and outputs A 0 ∼ 7, row address strobe signal, data buffer select signal are supplied in common to all memories M in Memory Array 50.

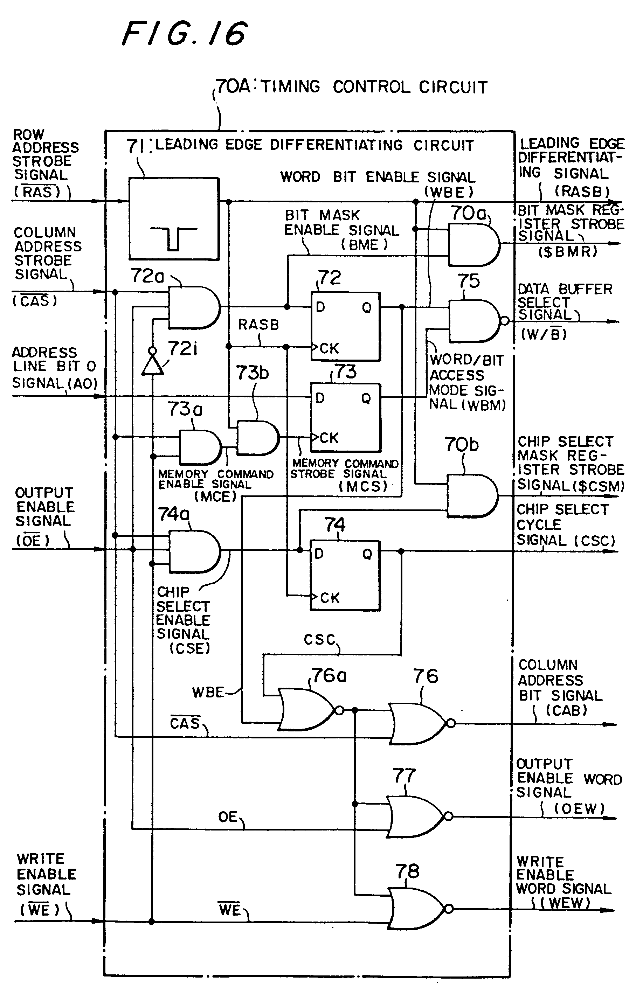

Referring now to Fig. 16, there is shown a circuit diagram to illustrate concretely the timing control circuit 70A shown in Fig. 14.

A differentiating circuit 71 is a circuit to create a front edge differentiation signal of the row address strobe signal, a flipflop 72 is a circuit to hold a word bit enable signal, and an AND gate 72a and an inverter 72i are respectively a circuit to output the above-mentioned word bit enable signal.

Also, a flipflop 73 is a flipflop to serve as a command register to specify a word/bit access mode, and is also adapted to store a value of an address line as a memory command.

AND circuits 73a, 73b are respectively adapted to create a memory command enable signal and a memory command strobe signal. AND Circuits 73a, 73b also form command receive cycle indicating means to allow a memory system to accept a memory command thereto. The term "memory system" used here means the whole circuit shown in Fig. 15.

A flipflop 74 is used to specify a chip select cycle (this means a memory cycle to create a program memory access),or, a VRAM access cycle (this means a memory cycle to perform an image memory access).

An AND circuit 74a is a circuit to create a chip select enable signal.

The values of the above-mentioned flipflops 72 ∼ 74 are determined by the input levels of other signals at a timing of the front or leading edge of the row address strobe signal.

A NAND circuit 75 is used to create a data buffer select signal. The output of NAND Circuit 75 becomes a "0" only when Flipflops 72 and 73 have been set, and, at that time, specify the bit-direction access.

NOR circuits 76a, 76, 77, 78 are respectively adapted to create the column address bit signal, output enable word signal, and write enable word signal. NOR circuits 76 ∼ 78 can be operated as AND circuits since the respective control signals thereof are input in the form of negative signals and they output a control signal at a cycle where the word enable signal and chip select cycle signal are set.

Also, there are provided an AND circuit 70a which serves to create a bit mask register strobe signal by the word bit enable signal and bit mask enable signal, and an AND circuit 70b which creates a chip select mask register strobe signal by the word bit enable signal and chip select enable signal.

Next, we will explain the operation of the above-mentioned embodiment using a time chart.

First, a condition to provide the program memory access is specified by the fact that,at a time just before the low address strobe signal becomes active, the column address strobe signal is a "1" and the write enable signal is a "1".

On the other hand, a condition to provide the VRAM access is specified by the fact that, at the above-mentioned time, the column address strobe signal is a "1" and the write enable signal is a "0".

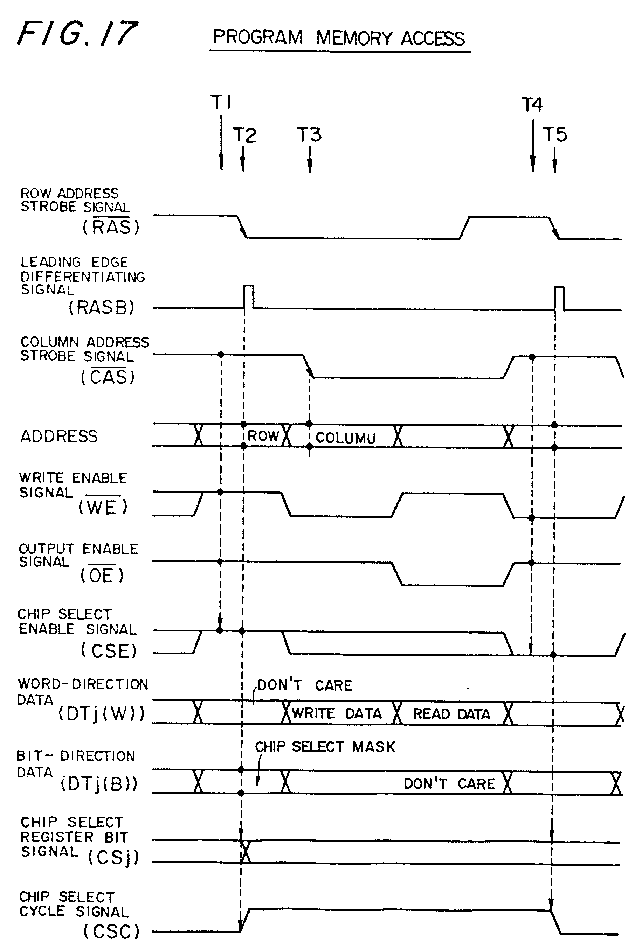

Now, Fig. 17 is a time chart to illustrate the operation of the program memory access.

At a time T 1, the column address strobe signal is in a "1" and the write enable signal is in a "1", thereby allowing the chip select enable signal to go to a "1".

At a time T 2, the row address is taken in and $CSM shown in Fig. 15 is issued, so that, in accordance with the value of the bit-direction data, the value of Chip Select Mask Register 67 is set and reset. Then, Flipflop 74 is set and enters the chip select cycle (program memory access). In this chip select cycle, normally, according to the address of a program, only 1 bit of Chip Select Mask Register 67 is set by Memory Controller 90.

When Flipflop 74 is set, then Read Control Selector 64S and Write Control Selector 65S respectively select the chip select information, and Memory Array 50 is now ready for use as an ordinary program memory.

Then, at a time T 3, the column address is taken in and reading or writing a program on Memory Array 50 is carried out.

At and from the time T 3, at a timing where the column address strobe signal is active, an ordinary read/write is controlled and executed by the write enable signal and output enable signal. At this time, since the word bit enable signal is a "0", the output of NAND Circuit 75 becomes a "1", thereby providing the word-direction access.

At following times T 4, T 5, the same operation as at the times T 1, T 2 is executed, thereby entering a next memory cycle.

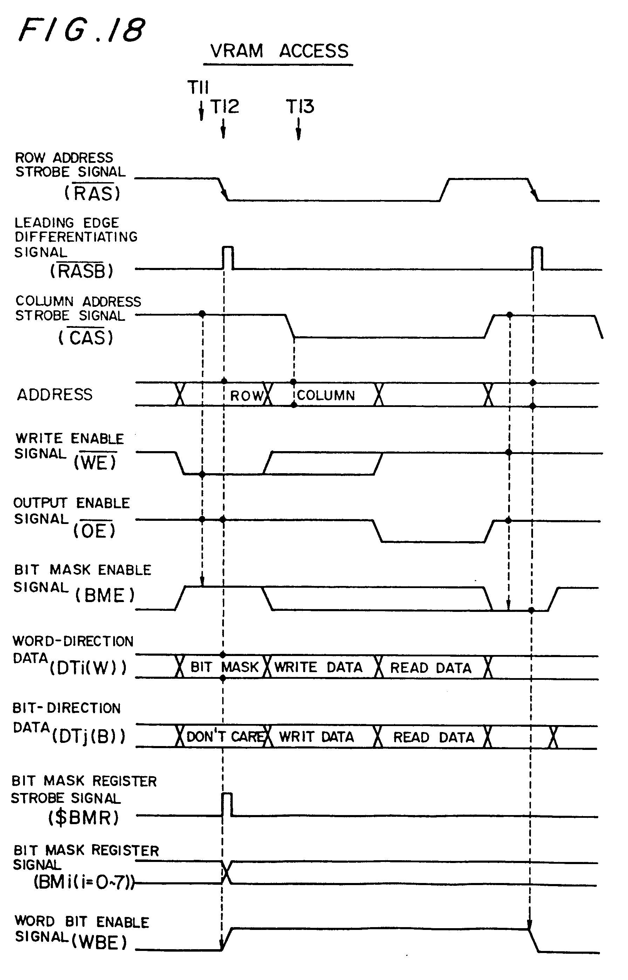

Referring now to Fig. 18, there is shown a time chart to illustrate the operation of the VRAM access.

At a time T 11, the column address strobe signal is a "1" and the write enable signal is a "0", so that the chip select enable signal goes to a "0".

On the other hand, the word bit enable signal goes to a "1", and, at a time T12, a row address is taken in and at the same time the word bir enable signal is set. Simultaneously with this, $BMR shown in Fig. 15 is output, with the result that the value of the word-direction data is loaded into Bit Mask Register 62.

In this cycle, since Flipflop 74 is not set, Read Control Selector 63S and Write Control Selctor 65S select the read plane mask information and write plane mask information (these two kinds of mask information are previously given from Memory Controller 90 or CPU), respectively. As a result of this, a condition to run the VRAM access to be described below is prepared.

And, at a time T 13, a coloumn address is taken in and, in Memory Array 50, VRAM writing or reading is executed.

In the VRAM access, since the word bit enable signal is set, the data buffer select signal is determined according to a word/bit access mode signal. As a result of this, the word access or bit access is provided. In this case, either the word-direction data bus or the bit-direction data bus is employed as the input/output of the data. Also, since Write Plane Mask Register 65 and Read Plane Mask Register 53 are effective as well as since Bit Mask Register 62 can be varied in each memory cycle, the VRAM access can be run dynamically.

Next, we will explain about a memory command.

Here, the term "memory command cycle" means an operation for a memory controller to specify an operation mode to a memory.

A condition to run the memory command cycle can be specified by the fact that, just before a timing where the row address strobe signal falls, the column address strobe signal is in a "0" and the write enable signal is in a "0".

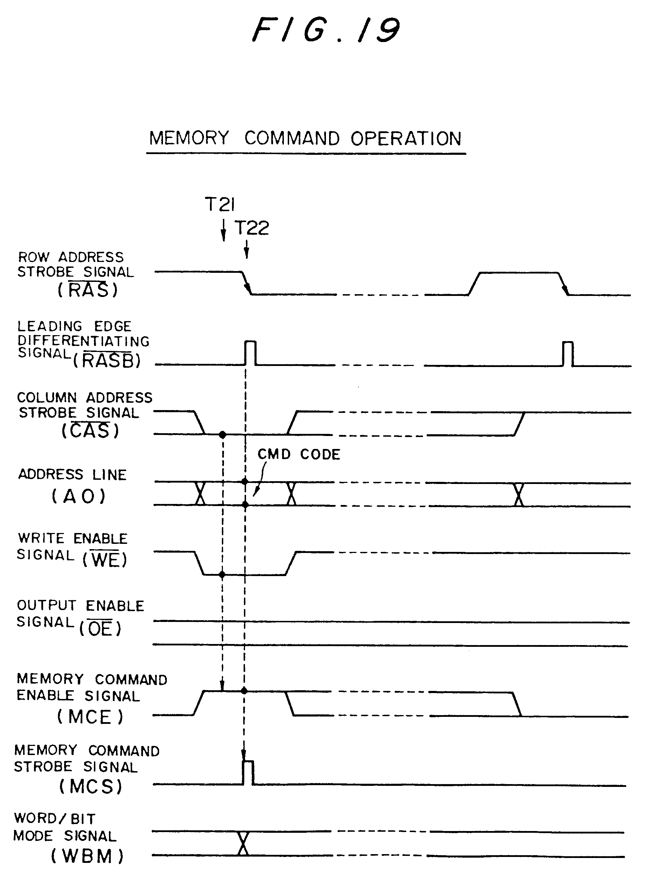

Referring now to Fig. 19, there is shown a time chart to illustrate the operation of the memory command.

At a time T 21, the column address strobe signal is in a "0" and the write enable signal is in a "0", whereby the output signal of AND Circuit 73a goes to a "1" and, at a time T 22, AND Circuit 73a outputs.

As a result of this, the value of the word/bit access mode signal is determined according to the value of the then address line bit 0 signal. Therefore, the controller is able to specify either the word access or the bit access according to the value of the address line bit 0 signal via the address line bit 0 signal. In this case, since the word bit enable signal and the chip select signal are not set, a control signal is not output to Memory Arrary 50.

Also, since the memory command cycle is similar to a conventional automatic refresh cycle ( cycle and hidden refresh cycle), the refreshment of the memory can also be executed simultaneously.

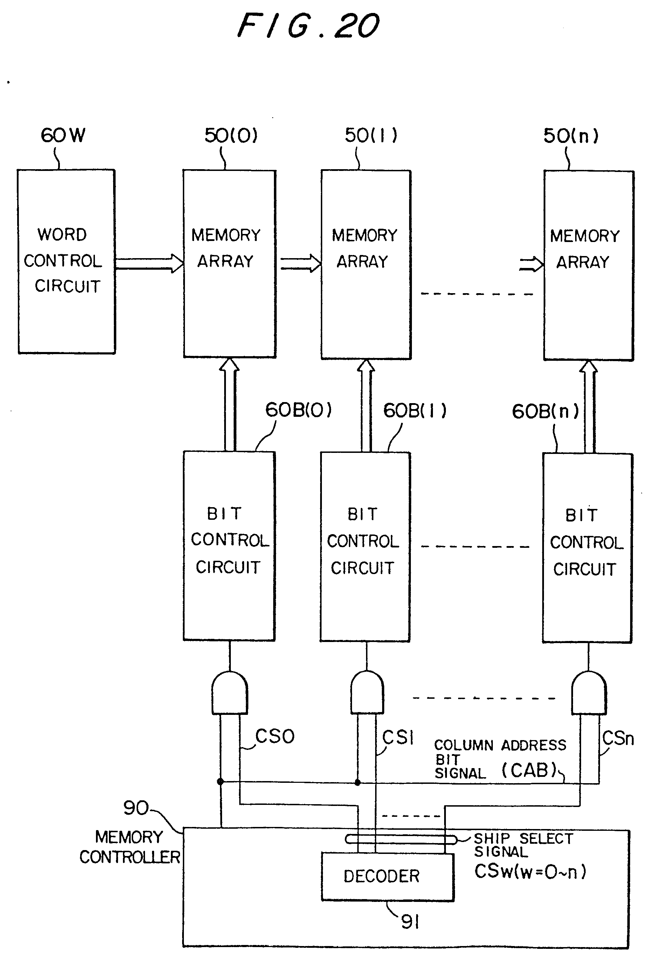

Now, Fig. 20 is a block diagram to show a modified version of the embodiment shown in Fig. 15.

In this embodiment, there are provided a plurality of Memory Arrays 50 shown in Fig. 15, and a plurality of Bit Control Circuits 60B; that is, they correspond to each other in number. And, both of them are selected by Memory Controller 90.

In other words, each of Memory Arrays 50 (0), 50(1) --- --- --- ---, 50 (n) is identical with Memory Array 50, while each of Bit Control Circuits 60B (0), 60B (0), --- --- --- ---, 60B (n) is identical with Bit Control Circuit 60B. And, one of Bit Control Circuits 60B (0) ∼ 60B (n) is specified in accordance with a chip select signal output from Decoder 91 within Memory Controller 90.

In this manner, an easy addressing can be achieved while a memory capacity is increased.

## Claims

1. A memory system to read or write data through data lines, said memory system comprising;
a memory array including a plurality of memory interfaces and a plurality of memories arranged one-dimensionally in a word direction via said memory interfaces, each of said memory interfaces comprising word-direction data buffers (20) serving as a word-direction input/output interface, bit direction data buffers (30) serving as a bit direction input/output interface and also adapted to operate independent of said word-direction data buffer; and data buffer select means (40) for selecting either of said two data buffers; characterised by direction control means (40, 42, 43) for controlling the direction of each of said two data buffers in accordance with a reading or writing operation on the memory contents of said memory system;
and wherein said memory array is split in the word direction into individually addressable pixels, each pixel comprising a plurality of bits, corresponding bits of a plurality of pixels being connected together at the side of said word direction data buffer away from the memory, and being connected to corresponding least significant bits of an input/output data bus, each of the bits of said plurality of pixels are connected to individual bits of said input/output data bus via the bit-direction data buffer, such that any single pixel can be accessed using the least significant bits of said data bus, or multiple pixels can be accessed simultaneously depending on the data buffer select means.

2. A memory system as claimed in claim 1, further comprising:
word direction inhibit mask means (163) for inhibiting read or write operations to or from selected memories in a word direction in said memory array, according to the contents of a mask register (164); and
bit-direction inhibit mask means (161) for inhibiting read or write operations from or to selected memories in a bit direction in said memory array, according to the contents of a second mask register (162), such that said memory input/output interface is operable to enable word-direction access or a bit-direction access in accordance with selected information from said data buffer select means and masking of data by said mask means.

3. A memory system as claimed in claim 2, wherein said word-direction inhibit mask means comprises:
a word-direction read inhibit mask means (64) for inhibit masking read operations from selected memories in a word direction in said memory array; and
a word-direction write inhibit mask means (66) for inhibit masking write operations to selected memories in said word direction in said memory array, said write inhibit mask means being operable independently of said read inhibit mask means.

4. A memory system as set forth in any preceding claim in which said memory array includes a plurality of input/output data lines extending in a word direction in said memory array and a plurality of input/output data lines extending in a bit direction in said memory array, said word-direction input/output signal lines being connected to said bit-direction input/output signal lines, one to one, in corresponding order.

5. A memory system as claimed in any of claims 2 to 4, in which the number of bits in said word direction is greater than the number of bits in said bit direction.

6. A memory system as claimed in any of claims 2 to 4, in which the number of bits in said word direction is smaller than the number of bits in said bit direction.

## Patentansprüche

1. Speichersystem zum Lesen und Schreiben von Daten über Datenleitungen, wobei das Speichersystem aufweist:
ein Speicherfeld mit mehreren Speicherschnittstellen und mehreren über die Schnittstellen eindimensional in einer Wortrichtung angeordneten Speichern, wobei jede Speicherschnittstelle Wortrichtungs-Datenpuffer (20), die als Eingangs/Ausgangs-Schnittstelle in Wortrichtung dienen, Bitrichtungs-Datenpuffer (30), die als Eingangs/Ausgangs-Schnittstelle in Bitrichtung dienen und auch angepaßt sind, unabhängig von dem Wortrichtungs-Datenpuffer zu arbeiten, aufweist; und eine Datenpufferauswahleinrichtung (40) für die Auswahl von einem der zwei Datenpuffer; gekennzeichnet durch eine Richtungssteuerungseinrichtung (40, 42, 43), um die Richtung von jedem der zwei Datenpuffer einem Lese- oder Schreibvorgang an den Speicherinhalten des Speichersystems entsprechend zu steuern;
und wobei das Speicherfeld in der Wortrichtung in individuell adressierbare Bildpunkte aufgesplittet ist, jeder Bildpunkt mehrere Bits aufweist, die Bits mehrerer Bildpunkte entsprechen, die auf der speicherabgewandten Seite des Worrichtungs-Datenpuffer miteinander verbunden sind und die mit den entsprechenden niedrigstwertigen Bits eines Eingangs/Ausgangs-Datenbusses verbunden sind, jedes Bit der mehreren Bildpunkte mit individuellen Bits des Eingangs/Ausgangs-Datenbusses über die Bitrichtungs-Datenpuffer verbunden ist, so daß auf jeden einzelnen Bildpunkt unter Verwendung der niedrigstwertigen Bits des Datenbusses oder daß auf mehrere Bildpunkte gleichzeitig in Abhängigkeit von der Datenpufferauswahleinrichtung zugegriffen werden kann.

2. Speichersystem nach Anspruch 1, das ferner aufweist:
eine Wortrichtungs-Sperrmaskeneinrichtung (163) zum Sperren von Lese- oder Schreibvorgängen zu oder von ausgewählten Speichern in einer Wortrichtung in dem Speicherfeld entsprechend den Inhalten eines Maskenregisters (164); und
eine Bitrichtungs-Sperrmaskeneinrichtung (161) zum Sperren von Lese- oder Schreibvorgängen von oder zu ausgewählten Speichern in einer Bitrichtung in dem Speicherfeld entsprechend den Inhalten eines zweiten Maskenregisters (162) in der Weise, daß die Speicher Eingangs/Ausgangs-Schnittstelle betreibbar ist, einen Wortrichtungszugriff oder einen Bitrichtungszugriff entsprechend einer aus der Datenpuffer-Auswahleinrichtung ausgewählten Information freizugeben und Daten durch die Maskeneinrichtung zu maskieren.

3. Speichersystem nach Anspruch 2, wobei die Wortrichtungs-Sperrmaskeneinrichtung aufweist:
eine Wortrichtungs-Lesesperrmaskeneinrichtung (64) zum Erzeugen einer Sperrmaske für Lesevorgänge von ausgewählten Speichern in einer Wortrichtung in dem Speicherfeld; und
eine Wortrichtungs-Schreibsperrmaskeneinrichtung (66) zum Erzeugen einer Sperrmaske für Schreibvorgänge auf ausgewählte Speicher in der Wortrichtung in dem Speicherfeld, wobei die Schreibsperrmaskeneinrichtung unabhängig von der Lesesperrmaskeneinrichtung betreibbar ist.

4. Speichersystem nach einem der vorstehenden Ansprüche, bei dem das Speicherfeld mehrere Eingangs/Ausgangs-Datenleitungen, die sich in einer Wortrichtung in dem Speicherfeld erstrecken, und mehrere Eingangs/Ausgangs-Datenleitungen enthält, die sich in einer Bitrichtung in dem Speicherfeld erstrecken, wobei die Eingangs/Ausgangs-Signalleitungen in Wortrichtung mit den Eingangs/Ausgangs-Signalleitungen in Bitrichtung eins zu eins in entsprechender Reihenfolge verbunden sind.

5. Speichersystem nach einem der Ansprüche 2 bis 4, bei dem die Anzahl der Bits in der Wortrichtung größer als die Anzahl der Bits in der Bitrichtung ist.

6. Speichersystem nach einem der Ansprüche 2 bis 4, bei dem die Anzahl der Bits in der Wortrichtung kleiner als die Anzahl der Bits in der Bitrichtung ist.

## Revendications

1. Système de mémoire pour la lecture ou l'écriture de données via des lignes de données, ledit système de mémoire comprenant une configuration de mémoire comprenant une pluralité d'interfaces de mémoire et une pluralité de mémoires disposées selon une dimension dans une direction de mot, via lesdites interfaces de mémoire, chacune desdites interfaces de mémoire comprenant des tampons de données de direction de mot (20) servant d'interface d'entrée/sortie de direction de mot, les tampons de données de direction binaires (30) servant d'interface d'entrée/sortie de direction binaire et prévus, de même, pour fonctionner indépendamment dudit tampon de données de direction de mot et un moyen de sélection de tampon de données (40) pour choisir un desdits deux tampons de données;
système caractérisé par des moyens de commande de direction (40, 42, 43) pour commander la direction de chacun desdits deux tampons de données selon une opération de lecture ou d'écriture des contenus de mémoire dudit système de mémoire et dans lequel ladite configuration de mémoire est partagée dans la direction de mot en pixels adressables, de façon individuelle, chaque pixel comprenant une pluralité de bits, des bits correspondants d'une pluralité de pixels étant raccordés sur le côté dudit tampon de donnée de direction de mot écarté de la mémoire et étant raccordés aux bits correspondant les moins significatifs d'un bus de données d'entrée/sortie, chacun des bits de ladite pluralité de pixels étant raccordés aux bits individuels dudit bus de données d'entrée/sortie, via le tampon de données de direction binaire, de telle façon qu'on puisse accéder à tout bit isolé à l'aide des bits les moins significatifs dudit bus de données ou à de multiples pixels, de façon simultanée, selon le moyen de sélection de tampon de données.

2. Système de mémoire selon la revendication 1, comprenant de plus :
- un moyen de masquage d'inhibition de direction de mot (163) pour inhiber des opérations de lecture ou d'écriture vers ou à partir des mémoires choisies dans une direction de mot de ladite configuration de mémoire selon le contenu d'un registre de masquage (164); et
- un moyen de masquage d'inhibition de direction binaire (161) pour inhiber des opérations de lecture ou d'écriture à partir de ou vers les mémoires choisies dans une direction binaire de ladite configuration de mémoire selon le contenu d'un second registre de masquage (162) de telle façon que ledit interface d'entrée/sortie de mémoire soit fonctionnel pour permettre un accès à la direction de mot ou à la direction binaire selon l'information choisie par ledit moyen de sélection de tampon de données et selon le masquage des données par ledit moyen de masquage.

3. Système de mémoire selon la revendication 2, dans lequel ledit moyen de masquage d'inhibition de direction de mot comprend :
- un moyen de masquage d'inhibition de lecture de direction de mot (64) pour inhiber le masquage d'opérations de lecture des mémoires choisies dans une direction de mot de ladite configuration de mémoire; et
- un moyen de masquage d'inhibition d'écriture de direction de mot (66) pour inhiber le masquage d'opérations d'écriture dans les mémoires choisies dans ladite direction de mot de ladite configuration de mémoire, ledit moyen de masquage d'inhibition d'écriture fonctionnant de façon indépendante dudit moyen de masquage d'inhibition de lecture.

4. Système de mémoire selon l'une quelconque des revendications précédentes, dans lequel ladite configuration de mémoire comprend une pluralité de lignes d'entrée/sortie de données s'étendant dans une direction de mot de ladite configuration de mémoire et une pluralité de lignes d'entrée/sortie de données s'étendant dans une direction binaire de ladite configuration de mémoire, lesdites lignes d'entrée/sortie du signal dans la direction de mot étant raccordées auxdites lignes d'entrée/sortie du signal dans la direction binaire, une à une, dans un ordre correspondant.

5. Système de mémoire selon l'une quelconque des revendications 2 à 4, dans lequel le nombre de bits dans ladite direction de mot est supérieur au nombre de bits dans ladite direction binaire.

6. Système de mémoire selon l'une quelconque des revendications 2 à 4, dans lequel le nombre de bits dans ladite direction de mot est inférieur au nombre de bits dans ladite direction binaire.
